# EUROPEAN PATENT APPLICATION

(11) **EP 1 376 237 A2**
(43) Date of publication of application: **02.01.2004**
(21) Application number: 03013976.0
(22) Date of filing: 20.06.2003
(51) Int. Cl.: G03F 7/20, G01M 11/02

(54) **Off-axis metrology of adaptive optical system**

(30) Priority: 21.06.2002 US 390156 P; 10.06.2003 US 457436
(71) Applicant: Nikon Corporation, Tokyo 100-8331 (JP)
(72) Inventor: Hazelton, Andrew J., San Carlos, CA94070 (US); Phillips, Alton H., Mountain View, CA 94041 (US)
(74) Representative: Viering, Jentschura & Partner

(57) **Abstract**

A metrology source and sensor arrangement are placed off-axis adjacent to and preferably coplanar with a reticle and target, respectively in a catoptic optical system suitable for EUV imaging. On-axis aberrations are derived by modelling of the optical system from off-axis metrology output. Adaptive optical elements are employed to minimize aberrations at acceptable levels for high precision and resolution exposures such as lithographic patterning.

## Description

### BACKGROUND OF THE INVENTION

### Cross-Reference to Related Applications

This application claims priority of U. S. Provisional Patent Application S. N. 60/390,156, filed June 21, 2002, entitled "Adaptive Optic Off-Axis Metrology" which is hereby fully incorporated by reference.

### Field of the Invention

The present invention generally relates to high precision imaging using a reflective optical element and, more particularly, to high precision lithography exposure systems and methods using one or more adaptive, reflective optical elements to minimize aberrations and measurement and control therefor.

### Description of the Prior Art

Many manufacturing and scientific processes require the use of optical systems having extremely high accuracy and precision and freedom from aberrations as well as the ability to make observations and/or exposures in wavelength regimes well outside the visible spectrum. For example, at least one lithographic exposure process is invariably required for establishing the location and basic dimensions of respective electrical or electronic elements in semiconductor integrated circuits in which the number of such elements on a single chip can extend into the tens if not hundreds of millions. The respective electrical or electronic elements can be very small and placement in close proximity, sometimes referred to as high integration density, is highly desirable in order to reduce signal propagation time and susceptibility to noise as well as to achieve other advantages such as increased functionality of chips and, in some cases, manufacturing economy. These circumstances provide strong incentives to develop smaller minimum feature size regimes which must be established through lithographic exposures of a resist. Therefore, resolution and aberration of the exposure must be held within a very closely defined budget which is a small fraction of the minimum feature size.

The resolution of any optical system is a function of the wavelength of the energy used for the exposure although some arrangements such as phase-shift masks have allowed exposure resolution to be extended below the wavelength of the exposure radiation. Nevertheless, resolution of extremely small features requires correspondingly short wavelengths of radiation. Accordingly, use of X-rays for lithographic exposure are known but not widely used due to the requirement for fabrication of an exposure mask at the same minimum feature size as the final desired pattern since reduction of the size of the pattern, sometimes referred to as demagnification, cannot be achieved with X-rays.

Optical and electron beam projection systems, however, can achieve such image pattern size reduction in the exposure pattern relative to feature sizes in a reticle which establishes the pattern to be exposed. However, between these two techniques, reticles for electron beam projection are generally far more expensive than optical reticles and, perhaps more importantly, require many more exposures to form a complete integrated circuit pattern since the exposure field at the chip is comparatively more limited in electron beam projection systems than in optical exposure systems. Therefore, there is substantial continued interest in optical lithographic exposure systems and extending their capabilities to shorter wavelengths, such as extreme ultraviolet (EUV).

EUV wavelengths are generally considered to be in the range of about 1 to 50 nanometers. Within this range, a suitable region for lithographic exposure is considered to be 12 to 14 nanometers and more specifically within a range of less than one nanometer in a band centered on 13.5 nanometers. At such wavelengths, most imaging materials which are transparent in the visible spectrum and which are suitable for lenses are substantially opaque to the imaging radiation. Therefore, optical systems have been developed and are known which have only reflective elements. Such fully reflective systems are usually more complex than transmissive lens systems since interference between illumination of the reticle and illumination of the target with the projected pattern must be avoided. This generally means that the number of elements must often be increased and the freedom from aberrations maintained or well-corrected throughout the entire optical system. The maintenance of high manufacturing yield in the above-discussed exemplary environment of semiconductor device manufacture thus requires not only high stability of the optical system but frequent measurement and adjustment to assure an adequately high level of optical performance of the system.

While techniques of measurement of wave-front aberrations are well-known and sufficient to accurately characterize the performance of optical systems and elements thereof, practical arrangements for conducting such measurements are difficult and complex. For instance, measurements cannot be made on axis or within the exposure/projection field during an exposure without interference with that exposure (e.g. by casting shadows or otherwise occupying a portion of the focal plane of the system where the target is located). Measurements performed between exposures cannot be regarded as measurements of optical performance during the exposure and do not directly characterize the lithographic image, itself, but are often the only practical solution at the current state of the art even though sources of error may be introduced. Optical performance generally degrades with increasing distance from the optical axis of the system and, as a practical matter, it is desirable to use as much of the field where sufficient precision, resolution and freedom from aberrations can be maintained for projection of the desired image; generally precluding such measurements which, in any event, may not directly or even predictably correspond to the on-axis performance of the element or system during exposure.

Active optics are known but have not been widely used to date. Active optics involve the ability to change the overall or local shape of one or more optical elements to alter the optical properties of the element or complete optical system. The article "Active Optics: A New Technology for the Control of Light" by John W. Hardy, Proc. of the IEEE, Vol 66, No. 6, June, 1978, provides an overview of this technology and is hereby fully incorporated by reference. In particular, some general suggestions for provision of mechanical arrangements for achieving localized or generalized deformations of reflecting optical elements to achieve different optical effects such as compensating for atmospheric turbulence are described. Nevertheless, measurement to achieve any particular optical effect remains extremely complex and difficult as discussed therein and the deformation of optical elements in accordance with such measurements for correction of aberrations is limited and difficult to control.

### SUMMARY OF THE INVENTION

The present invention provides an optical system operable at EUV wavelengths employing simplified measurement of aberrations of improved correspondence to optical performance during use (e.g. for lithographic exposures) and including one or more adaptive optical elements for optimization of optical performance and minimization of aberrations of a optical system having at least one reflective optical element.

The invention provides an apparatus and method for measuring the aberration of a reflective optical element using an off-axis, possibly non-actinic light source for correcting aberrations using one or more adaptive optics and/or using partial samples taken during exposures and stitched together to determine the aberration.

### BRIEF DESCRIPTION OF THE DRAWINGS

The foregoing and other objects, aspects and advantages will be better understood from the following detailed description of a preferred embodiment of the invention with reference to the drawings, in which:
Figure 1 is a schematic diagram of a known exemplary catoptic optical design with which the invention may be employed, and
Figure 2 is a schematic diagram of a preferred embodiment of the invention as applied to a catoptic optical system similar to that of Figure 1.

### DETAILED DESCRIPTION OF A PREFERRED EMBODIMENT OF THE INVENTION

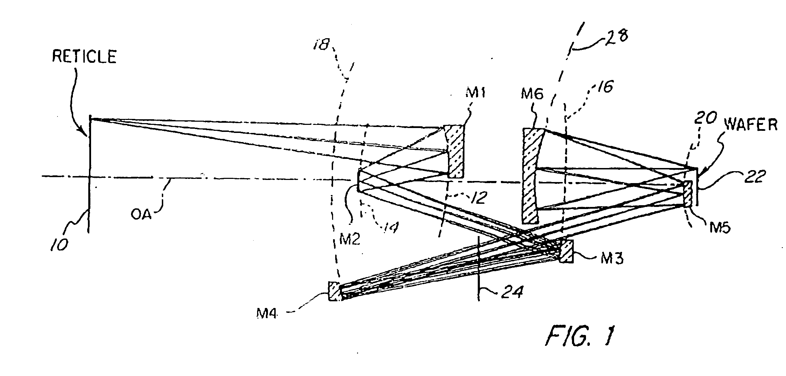

Referring now to the drawings, and more particularly to Figure 1, there is shown an exemplary known catoptic optical imaging system with which the invention may be employed. The optical system shown corresponds to Figure 1 of U. S. Patent 5,815,310 to Williamson which is hereby fully incorporated by reference, particularly for a detailed description thereof. All optical elements of this optical system are reflective and thus the optical system is suitable for projection of EUV wavelengths. The illustrated optical system is suitable for image projection of a pattern established by the reticle 10 onto a target 22 such as a resist-coated wafer. It should be further noted that this optical system is relatively complex; including six mirrors, M1 - M6, the respective curvatures of which are depicted by dashed lines 12, 14, 16, 18, 20 and 28, and having a tortuous optical path among the elements and principally off-axis (e.g. separated from optical axis OA) which, itself, may give rise to significant aberrations.

In accordance with the invention, adaptive optics may be employed for any or all elements of the optical system of Figure 1 or any similar system having reflectors for all elements thereof and thus capable of projecting an image using EUV radiation or, for longer wavelengths, having a reflector for any optical element thereof to allow adaptive correction to be performed. However, it is necessary to provide for measurements of any existing aberrations at least periodically (e.g. possibly as infrequently as once per week for measurement of total aberration) such that corrective action can be taken to adjust the adaptive optic to reduce aberrations to an allowable amount. However, such adjustment, even for a relatively stable optical system does not guarantee substantially optimal optical performance during use or that changes in conditions during use will not affect optical performance.

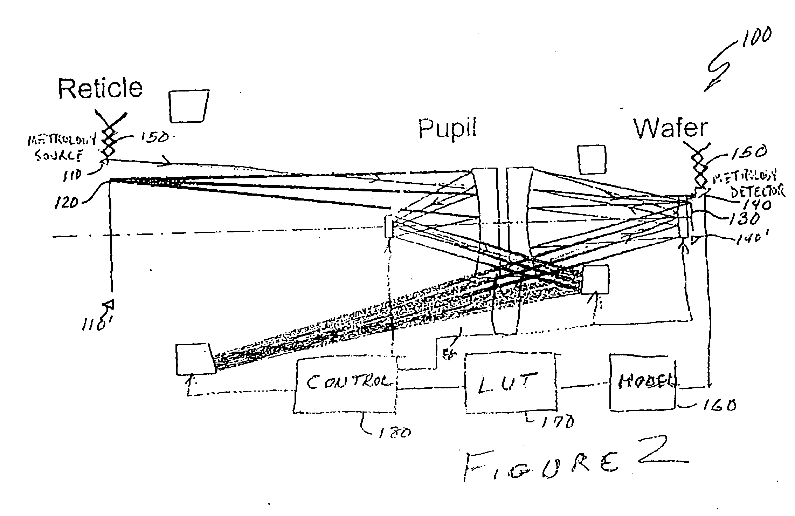

Referring now to Figure 2, the metrology system 100 in accordance with the invention is installed as part of the projection/imaging optical system. A light source 110, preferably with a non-actinic wavelength (e.g. light to which the resist is not sensitive) different from the exposure wavelength (as is easily possible since no optical elements are refractive and the optical characteristics of the optical system will thus be the same at any wavelength although resolution may be wavelength limited) is situated slightly off-axis from the exposure light passing the reticle 120, depicted as a location on the reticle. Because the metrology light source 110 is outside the reticle/image area and off-axis from the exposure light source and the target/wafer 130 generally corresponds with the area of at least a portion of the reticle, the output metrology beam will be in a different location (e.g. outside the area of the projected image) from the wafer being exposed. Therefore, it is possible to locate a sensor 140 at the output location and to measure the aberration during exposure or without significant interruption of or interference with the exposure process.

Accordingly, conditions of exposure may be fully or substantially maintained during measurement. It is also possible to sample a portion of the metrology output during changes or alignment of wafers and then splice the partial results together to create a map of the aberration(s). Because the metrology is slightly off-axis, a model such as may be empirically derived, possibly including interpolation, and preferably in the form of a look-up table, should be used to correlate the metrology results with actual performance and corrections appropriate to optimize performance.

In other words, while it is recognized that aberrations can only be well-corrected within a relatively small distance of the optical axis of the optical system, the invention exploits the correlation between the optical system characteristics when well-corrected and the generally larger aberrations which will be observed off-axis and outside the image area region considered to be well-corrected. Therefore, a change in the off-axis aberrations will not only reflect a change or instability of correction of the optical system, often with increased sensitivity, but will quantitatively reflect, through modelling or collection of empirical data or a combination thereof, 'a quantitative characterization of the imaging performance and correction needed to return the optical system to a well-corrected state.

The catoptic optical imaging system shown in Figure 2 is similar to that of Figure 1 except that full annular elements (rather than segments thereof, as in Figure 1) are shown. The metrology source 110 is illustrated as adjacent to and preferably coplanar with the reticle. The metrology sensor 140 is correspondingly located adjacent to the target/wafer and preferably coplanar therewith but may be shifted slightly in the axial direction to compensate for field curvature. The metrology detector could, for example, be a point diffraction interferometer of a known type such as a Sommargren interferometer, as is discussed, for example in "Sub-nanometer Interferometry for Aspheric Mirror Fabrication" by G. R.. Sommargren et al.; 9^{th} Int. Conf. on Production Engineering, Osaks, Japan; 8/30 - 9/1, 1999; UCRL-JC-134763 and "Phase Shifting Diffraction Interferometry for Measuring Extreme Ultraviolet Optics" by G. E. Sommargren; OSA TOPS on Extreme Ultraviolet Lithography, 1996; pp. 108 - 112, and "100-picometer interferometry for EUVL" by G. E. Sommargren et al.; Emerging Lithographic Technologies VI; Proceedings of SPIE, Vol 4688; pp. 316 - 328, all of which are fully incorporated herein by reference. The metrology system is thus off-axis from and does not interfere with the exposure system. The metrology detector can either be sampled during exposure or may be sampled between exposures or between wafers. In addition, as a variation or supplement to the invention the sensor and detector or another sensor and detector of similar or different type could be attached to respective retractable arms 150 that can be inserted and retracted between exposures or between wafers. This can be particularly useful for performing additional on-axis metrology to confirm and/or calibrate off-axis metrology or used independently for system adjustment. Additionally, a plurality of the systems of Figure 2 could be employed around the optical axis (e.g. around the periphery of the reticle and wafer) or, alternatively, the metrology system of Figure 2 could be moved and measurements made at different locations (as schematically depicted at 110',140') and the measurements stitched together to form a more complete evaluation of the optical system performance. Other metrology systems could, of course be used.

Once the aberrations of the system are determined from the aberrations detected by the off-axis (or on-axis) metrology system through, for example, modelling 160, the appropriate corrections of the shape of any or all optical elements of the system may be determined from, for example, a look-up table (LUT) 170 developed empirically or through modelling and corrections passed to a control arrangement 180, the details of which are unimportant to the practice of the invention, to control suitable mechanical arrangements for altering the shape of the adaptive optical element(s). Preferred mechanical arrangements are disclosed in concurrently filed U. S. Provisional Patent Applications (Attorney's docket Numbers PAO-485/PAO-504, PAO-493 and PAO-486), assigned to the assignee of the present invention and hereby fully incorporated by reference.

In view of the foregoing, it is seen that the invention provides for quantitative determination of optical performance of an optical system without interfering with use of the optical system and correction of aberrations performed automatically to compensate for changes in conditions during use of the optical system. The wavelength of light used for measurement may be freely chosen to further avoid interference with use of the optical system at a given wavelength. The invention can thus assure that substantially optimum performance of the optical system is maintained during, for example, a lithographic exposure during semiconductor device manufacture to assure quality and uniformity of the manufactured devices.

While the invention has been described in terms of a single preferred embodiment, those skilled in the art will recognize that the invention can be practiced with modification without departing from the spirit and scope of the invention.

## Claims

1. A method of quantitative determination of optical performance of an optical system including steps of
measuring said aberrations of said optical system outside an image area, and
determining optical performance within said image area based on results of said measuring step.

2. A method as recited in claim 1, further including a step of
correlating optical performance within an image area with aberrations of the optical system outside the image area.

3. A method as recited in claim 2, wherein said correlating step is performed by modelling.

4. A method as recited in claim 2, wherein said correlating step is performed by collecting empirical data.

5. A method as recited in claim 2, further including a step of
adjusting said optical system in accordance with said correlating step.

6. A method as recited in claim 1, wherein said measuring step is performed with light of a non-actinic wavelength.

7. A method as recited in claim 1, wherein said measurement step is performed during projection of an image through said optical system.

8. A method as recited in claim 7, including the further step of measuring on-axis performance of the optical system between projection of images through said optical system.

9. A method as recited in claim 7, including the further step of taking samples within said image area between projections of images.

10. A method of correcting aberrations in a optical system comprising steps of
measuring said aberrations of said optical system outside the image area,
determining a correction for an adaptive optical element to improve optical performance of said optical system within said image area based on results of said measuring step.

11. A method as recited in claim 10, further including a step of
correlating optical performance within an image area with aberrations of the optical system outside the image area.

12. A method as recited in claim 11, further including a step of
adjusting said optical system in accordance with said correlating step.

13. A method as recited in claim 11, wherein said correlating step is performed by modelling.

14. A method as recited in claim 11, wherein said correlating step is performed by collecting empirical data.

15. A method as recited in claim 10, wherein said measuring step is performed with light of a non-actinic wavelength.

16. A method as recited in claim 10, wherein said measurement step is performed during projection of an image through said optical system.

17. A method as recited in claim 16, including the further step of measuring on-axis performance of the optical system between projection of images through said optical system.

18. A method as recited in claim 16, including the further step of taking samples within said image area between projections of images,

19. A method as recited in claim 11, wherein results of said correlating step are stored in the form of a look-up table and accessed during said determining step.

20. An optical system including
an adaptive optical element,
a light source and sensor located off-axis outside an image area of said optical system,
means for determining optical performance within an image area of said optical system based on an output of said sensor, and
means for controlling said adaptive optical element in accordance with an output of said means for determining optical performance.

21. An optical system as recited in claim 20, wherein said means for determining optical performance includes a look-up table.

22. An optical system as recited in claim 20, wherein said light source and sensor are movably positioned by a retractable structure.

23. An optical system as recited in claim 20, wherein said light source provides non-actinic wavelength light.

24. A method of correcting aberrations of an optical system for projecting a pattern defined on a reticle onto a wafer using EUV radiation, said reticle including off-axis image areas, said method comprising steps of
measuring said aberrations of said optical system outside said off-axis image areas, and
determining a correction for an adaptive optical element to reduce said aberrations of said optical system within said off-axis image area based on results of said measuring step.

25. A method as recited in claim 24, wherein said measuring step is performed during projection.

26. A method for correcting aberrations on an optical system for projecting a pattern defined on a reticle onto a wafer using EUV radiation, said image area of said reticle including off-axis image areas, said method comprising steps of
measuring said aberrations of said optical system inside said off-axis image areas, and
determining a correction for an adaptive optical element to reduce said aberrations of said optical system within said image area based on results of said measuring step.
